# DEMANDE DE BREVET EUROPEEN

(11) **EP 3 876 685 A1**
(43) Date de publication de la demande: **08.09.2021**
(21) Numéro de dépôt: 21160891.4
(22) Date de dépôt: 05.03.2021
(51) Int. Cl.: H05K 3/02, G06K 19/077, H05K 3/30, H05K 3/20, H05K 3/40, H05K 1/18

(54) **PRÉLAMINÉ POUR UNE CARTE ÉLECTRONIQUE, ET PROCÉDÉS DE RÉALISATION D'UN TEL PRÉLAMINÉ ET D'UNE CARTE ÉLECTRONIQUE COMPORTANT UN TEL PRÉLAMINÉ**

(30) Priorité: 06.03.2020 FR 2002275
(71) Demandeur: IDEMIA France, 92400 Courbevoie (FR)
(72) Inventeur: GAC, Philippe, 92400 Courbevoie (FR); ESCOFFIER, Pierre, 92400 Courbevoie (FR); LAVARENNE, Rémi, 92400 Courbevoie (FR)
(74) Mandataire: Santarelli

(57) **Abrégé**

La présente invention concerne prélaminé pour carte électronique, dans lequel au moins un premier groupe de plages de connexion est formé d'une plaque métallique (10) formée d'une pièce comportant une partie centrale (11) et des branches (12) s'étendant depuis la partie centrale (11), les branches (12) de la plaque métallique (10) formant les plages de connexion du premier groupe. L'invention concerne aussi un procédé de réalisation d'un tel prélaminé et d'une carte électronique comportant un tel prélaminé.

## Description

La présente invention concerne un prélaminé pour une carte électronique comportant un module encarté.

Elle concerne également des procédés de réalisation d'un tel prélaminé et d'une telle carte électronique.

Une carte électronique telle que considérée ici comporte typiquement un corps et au moins un composant électronique intégré dans le corps, soit au sein du corps, soit dans une cavité formée dans le corps et débouchant à une surface du corps. Généralement, plusieurs composants électroniques sont présents.

Un composant électronique placé dans une cavité du corps et débouchant à une surface du corps est par exemple un module encarté.

Plusieurs connexions doivent généralement être établies avec un composant électronique, ou entre deux des composants présents dans la carte et devant échanger des signaux entre eux.

Pour supporter au moins une partie d'un circuit électronique relié à au moins un composant électronique, la carte électronique peut comporter par exemple un prélaminé, ou/et un flex, par exemple en polyimide (c'est-à-dire un circuit imprimé en polyimide avec des composants électroniques montés dessus), compris dans une épaisseur de la carte électronique.

Un prélaminé comporte typiquement au moins une couche de substrat, par exemple en PVC, sur lequel est formé au moins un groupe de plages de connexion.

Or, chaque plage de connexion est réalisée et disposée individuellement, par exemple par collage.

A titre illustratif, une plage de connexion mesure de l'ordre de 2 mm x 6 mm, pour environ 0,1 mm en épaisseur.

Un composant électronique est ensuite connecté aux plages de connexion du groupe correspondant.

Eventuellement, des fils de connexion relient au moins certaines de ces plages à des plages de connexion d'un autre groupe, afin de connecter deux composants électroniques entre eux par exemple.

La formation et le positionnement de chacune des plages de connexion, pour chacun des groupes nécessaires, requiert donc une grande minutie et un temps directement dépendant du nombre de plages de connexion à réaliser.

En outre, la précision dans la réalisation de chacune des plages de connexion est un facteur clef pour favoriser une connexion satisfaisante et fiable avec un composant électronique et/ou entre deux composants électroniques, par exemple pour au moins permettre une transmission de signal satisfaisante entre eux.

La présente invention vise ainsi à résoudre au moins en partie les inconvénients précités, menant en outre à d'autres avantages.

La présente invention vise notamment faciliter la réalisation de plages de connexion dans un prélaminé.

A cet effet, est proposé selon un premier aspect, un prélaminé pour une carte électronique, comportant au moins deux substrats et au moins un premier groupe de plages de connexion assemblées entre les deux substrats, caractérisé en ce que le prélaminé comporte une plaque métallique formée d'une pièce comportant une partie centrale et des branches s'étendant depuis la partie centrale, les branches de la plaque métallique formant les plages de connexion du premier groupe.

Grâce à une telle plaque métallique formée d'une seule pièce, la disposition des plages de connexion dans un prélaminé est ainsi grandement facilitée et accélérée.

Il est ainsi possible de n'effectuer qu'une seule opération de positionnement quel que soit le nombre de plages de connexion à disposer dans un prélaminé.

En fonction de l'application envisagée, la plaque métallique comporte autant de branches que de nombre de plages de connexion nécessaires pour un composant électronique.

Ainsi, la plaque métallique comporte par exemple au moins deux branches, de préférence au moins trois branches, par exemple au moins six branches.

Par exemple, le prélaminé comporte au moins un deuxième groupe de plages de connexion, au moins l'une des plages de connexion du deuxième groupe étant reliée à une des branches de la plaque métallique par un fil de connexion.

Un tel prélaminé permet ainsi de relier au moins deux composants électroniques entre eux.

Selon un exemple de réalisation intéressant, le prélaminé comporte une deuxième plaque métallique formée d'une pièce comportant une partie centrale et des branches s'étendant depuis la partie centrale, les branches de la deuxième plaque métallique formant les plages de connexion du deuxième groupe.

La réalisation d'un tel prélaminé est ainsi encore davantage facilitée lorsque plusieurs composants électroniques sont requis.

Dans un exemple particulier, le prélaminé comporte une antenne ayant deux extrémités, les deux extrémités de l'antenne étant reliées à deux des branches de la plaque métallique du premier groupe.

Une telle antenne permet par exemple un fonctionnement sans contact pour carte électronique.

L'invention concerne aussi une carte électronique comportant un prélaminé tel que décrit précédemment, ainsi qu'une première cavité formée à partir d'une surface de la carte électronique, la première cavité ayant un fond dans lequel débouchent les plages de connexion du premier groupe, et un premier module encarté dans la première cavité et connecté aux plages de connexion du premier groupe.

La partie centrale de la plaque métallique a par exemple été retirée, isolant ainsi les plages de connexion les unes des autres.

Par exemple, la carte électronique comporte une deuxième cavité formée à partir d'une surface de la carte électronique, la deuxième cavité ayant un fond dans lequel débouchent les plages de connexion du deuxième groupe, et un deuxième module encarté dans la deuxième cavité et connecté aux plages de connexion du deuxième groupe.

Dans un exemple de réalisation intéressant, le premier module comporte une puce à fonctionnement dual, et le deuxième module comporte un capteur biométrique.

Est également proposé, selon un autre aspect de l'invention, un procédé de réalisation d'un prélaminé tel que décrit précédemment. Le procédé comporte par exemple :
- Une étape de fourniture d'au moins deux substrats ;
- Une étape de fourniture d'une plaque métallique formée d'une pièce comportant une partie centrale et des branches s'étendant depuis la partie centrale, les branches formant un premier groupe de plages de connexion ;
- Une étape de mise en place de la plaque métallique par rapport à au moins un premier des deux substrats ;
- Une étape de laminage des au moins deux substrats, la plaque métallique étant entre les deux substrats.

Grâce à une telle plaque métallique formée d'une seule pièce, la réalisation d'un prélaminé est plus aisée et plus rapide à mettre en œuvre. Elle permet aussi une meilleure précision dans la disposition des plages de connexion.

Il est ainsi possible de n'effectuer qu'une seule opération de positionnement quel que soit le nombre de plages de connexion à disposer dans un prélaminé.

Dans un exemple de mise en œuvre, l'étape de mise en place de la plaque métallique avec au moins le premier des deux substrats comporte une étape d'incrustation de la plaque métallique dans le premier substrat.

Selon un exemple intéressant, le procédé comporte en outre une étape de fourniture d'un deuxième groupe de plages de connexion, et une étape de mise en place d'au moins une des plages de connexion du deuxième groupe à une des branches de la plaque métallique par un fil de connexion.

Dans un exemple intéressant, le procédé comporte une étape de fourniture d'une antenne ayant deux extrémités, et une étape de liaison des deux extrémités de l'antenne à deux des branches de la plaque métallique.

Est également proposé, selon un autre aspect de l'invention, un procédé de réalisation d'une carte électronique comportant :
- Des étapes de procédé de réalisation d'un prélaminé tel que décrit précédemment ; et
- Une étape d'usinage comportant au moins une sous-étape de retrait de la partie centrale de la plaque métallique du premier groupe de plages de connexion et une sous-étape de mise à nu d'au moins une des branches de la plaque métallique formant une plage de connexion du premier groupe.

Dans un exemple de mise en oeuvre, le procédé comporte en outre une étape de fourniture de deux couches de couverture, et une étape de laminage du prélaminé entre les deux couches de couverture disposées de part et d'autre du prélaminé. Dans un exemple particulier, l'étape d'usinage comporte en outre une sous-étape de retrait d'une partie centrale d'une plaque métallique formant un deuxième groupe de plages de connexion et une sous-étape de mise à nu d'au moins une plage de connexion du deuxième groupe.

Selon un exemple intéressant, le procédé comporte en outre une étape d'encartage et de connexion d'un premier module à des plages de connexion du premier groupe.

Le cas échéant, le procédé comporte aussi une étape d'encartage et de connexion d'un deuxième module à des plages de connexion du deuxième groupe.

L'invention, selon un exemple de réalisation, sera bien comprise et ses avantages apparaitront mieux à la lecture de la description détaillée qui suit, donnée à titre indicatif et nullement limitatif, en référence aux dessins annexés dans lesquels :
- la figure 1 représente schématiquement un exemple de réalisation d'un groupe de plages de connexion dans un prélaminé selon l'art antérieur ;
- la figure 2 illustre un groupe de plages de connexion réalisé par une plaque métallique d'une seule pièce selon un exemple de réalisation de l'invention ;
- la figure 3 montre une disposition de plaques métalliques de la figure 2 dans un prélaminé ; et
- la figure 4 illustre schématiquement une carte après usinage comportant un prélaminé et des cavités, selon un exemple de réalisation de l'invention.

Les éléments identiques représentés sur les figures précitées sont identifiés par des références numériques identiques.

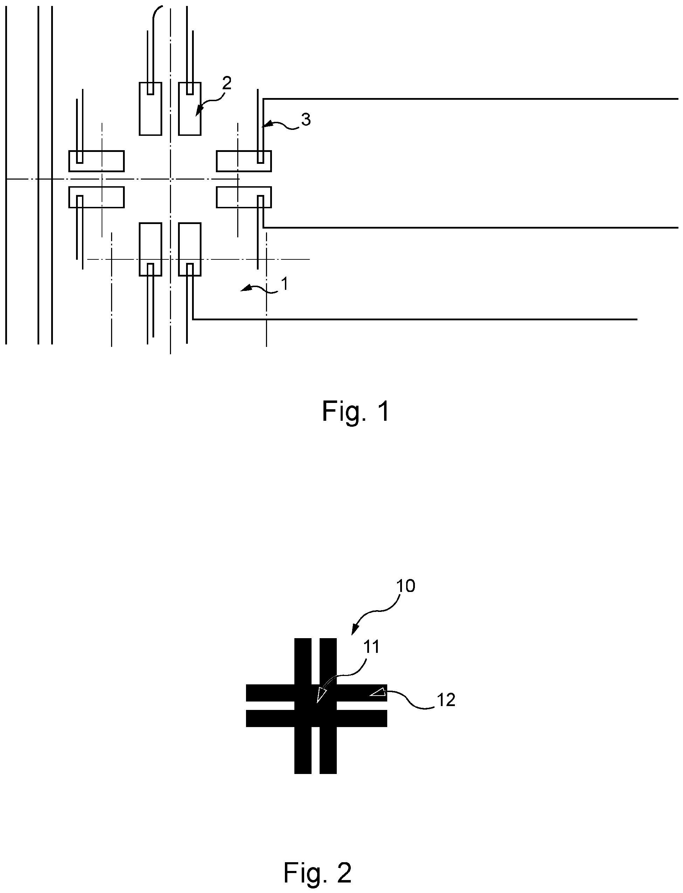

Comme l'illustre la figure 1, traditionnellement, un prélaminé comporte au moins un substrat 1 et des plages de connexion 2, nécessaires pour connecter un composant électronique, qui sont réalisées et disposées individuellement, souvent par collage par exemple, sur le substrat 1.

A titre illustratif, une plage de connexion 2 mesure de l'ordre de 2 mm x 6 mm en surface, pour environ 0,1 mm en épaisseur.

Au moins certaines des plages de connexion 2 peuvent par ailleurs être reliées par un fil de connexion 3 à un autre composant électronique, non représenté, lequel est connecté via d'autres plages de connexion, non visibles sur cette figure, également formées et disposées sur le substrat 2.

Dans l'exemple de réalisation de la figure 1, le substrat 1 est muni de huit plages de connexion 2, à chacune desquelles est relié ici un fil de connexion 3.

La formation et le positionnement de chacune des plages de connexion selon une précision souhaitée est alors difficile à maitriser et requiert donc une grande minutie et un temps directement dépendant du nombre de plages à réaliser.

Pour améliorer la réalisation d'un tel prélaminé, et en particulier faciliter la disposition des plages de connexion destinées à être reliées à un composant électronique, les plages de connexion selon l'invention sont conjointement formées en une même plaque métallique 10, représentée figure 2.

La plaque métallique 10 est formée d'une seule pièce et comporte une partie centrale 11 et des branches 12 s'étendant depuis la partie centrale 11. Ainsi, toutes les branches sont reliées les unes aux autres grâce à la partie centrale.

Chacune des branches 12 est ainsi configurée pour former une plage de connexion d'un groupe de plages de connexion permettant ultérieurement d'y connecter un composant électronique.

Une fois la plaque métallique 10 positionnée dans un substrat, la partie centrale 11 est retirée et chacun des branches 12 est ainsi isolée des autres.

Ici, dans l'exemple de réalisation de la figure 2, la plaque métallique 10 comporte huit branches 12, disposées en croix par groupes de deux.

Ainsi, la plaque métallique 10 de la figure 2 est configurée pour remplacer le groupe de plages de connexion 2 de la figure 1 par exemple.

Le nombre de branches dépend toutefois de l'application envisagée.

La plaque métallique 10 est par exemple réalisée en cuivre.

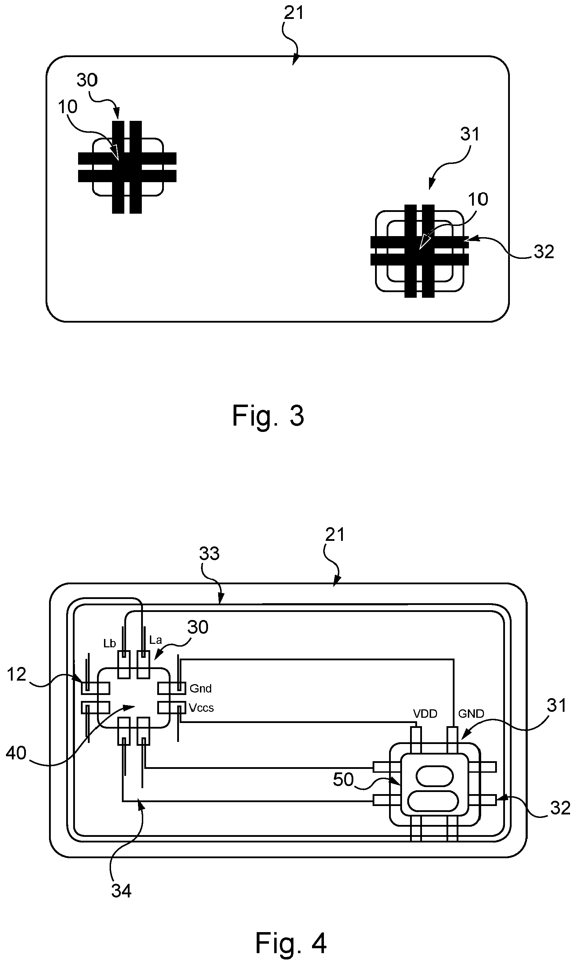

Comme l'illustre la figure 3, la disposition des plages de connexion dans un prélaminé est ainsi grandement facilitée et accélérée, notamment du fait qu'il est possible de n'effectuer qu'une seule opération de positionnement quel que soit le nombre de plages de connexion à disposer dans un prélaminé.

La figure 3 montre un substrat 21 d'un tel prélaminé.

Un tel substrat est par exemple en PVC ou PET.

Le substrat 21 présente ici une forme correspondant à celle d'un prélaminé d'une carte électronique auquel il est destiné.

Le substrat 21 comporte ici deux groupes de plages de connexion : un premier groupe 30 de plages de connexion et un deuxième groupe 31 de plages de connexion. Conformément à l'invention, une plaque métallique 10 telle que celle représentée figure 2 est disposée sur le substrat 21 afin de former les plages de connexion du premier groupe 30 de plages de connexion pour y relier ultérieurement un composant électronique.

Ici, les huit plages de connexion souhaitées sont ainsi placées sur une surface du substrat 21 en une seule opération.

Pour certains domaines d'application, il peut être souhaitable de réaliser un prélaminé configuré pour connecter entre eux au moins deux composants électroniques, comme par exemple une puce et un capteur biométrique.

Pour ce faire, comme le montre la figure 3, le substrat 21 est alors muni du deuxième groupe 31 de plages de connexion 32.

Le deuxième groupe 31 de plages de connexion peut être réalisé en disposant chacune des plages de connexion 32 individuellement, ou, comme illustré, en utilisant une deuxième plaque métallique 10 conformément à l'invention, par exemple telle que celle représentée figure 2 selon le nombre de plages de connexion souhaité, ce qui facilite d'autant plus la réalisation du prélaminé concerné.

Dans le présent exemple de réalisation, le deuxième groupe 31 de plages de connexion comporte également huit plages de connexion 32.

Pour réaliser le prélaminé sur cette base, chacune des plaques métalliques 10 requise pour l'application considérée est par exemple disposée sur le substrat 21.

Au besoin, au moins une des branches 12 et/ou la partie centrale 11 peut être collée sur le substrat 21.

Il peut être prévu de réaliser au moins un point de soudure localement pour venir faire fondre du matériau du substrat 21 sur la plaque métallique 10 et créer ainsi un point de liaison de sorte que la plaque métallique 10 est maintenue, par exemple avant et pendant une étape de laminage.

Un deuxième substrat, non représenté, peut par exemple être appliqué sur le premier substrat 21, au moins la plaque métallique 10 étant disposée entre les deux substrats. Selon un autre exemple, le substrat, incluant la plaque métallique 10, est pris en sandwich entre deux autres substrats, c'est-à-dire qu'un troisième substrat est alors disposé sur une face opposée du substrat 21 par rapport à celle comportant la plaque métallique 10.

Dans un exemple de réalisation, un substrat du prélaminé peut comporter une fenêtre dans laquelle la plaque métallique 10 est disposée.

Une pastille adhésive de dimensions plus grandes que celles de la fenêtre peut être collée sur une face du substrat correspondant pour fermer la fenêtre. Ainsi la plaque métallique est déposée et maintenue par la pastille adhésive.

Le substrat 21, éventuellement recouvert par au moins un autre substrat, voire pris en sandwich entre deux autres substrats, est ensuite chauffé et pressé pour former le prélaminé.

Le prélaminé obtenu a par exemple une épaisseur d'au plus 500 µm, voire 430 µm. Ensuite, pour réaliser une carte électronique comportant le prélaminé tel que décrit précédemment, le prélaminé est par exemple laminé entre deux couches de couvertures, disposées de part et d'autre du prélaminé.

Une étape d'usinage permet ensuite de former au moins une première cavité.

Durant cette étape, la partie centrale 11 de la plaque métallique 10 est retirée, ce qui isole alors, au moins électriquement, chacune des branches 12 par rapport aux autres branches.

En outre, au moins certaines des branches 12 sont dénudées, ce qui permet d'y relier ultérieurement un composant électronique, par exemple une puce d'un module.

Dans un tel cas, l'étape d'usinage affecte donc au moins une des couches de couverture et/ou au moins une partie du prélaminé, par exemple un substrat recouvrant la plaque métallique 10.

Il peut en être de même pour la formation d'une deuxième cavité pour connecter un deuxième module au deuxième groupe 31 de plages de connexion 32.

Sur la figure 4, une carte électronique comportant un substrat 21 tel que décrit précédemment est en outre munie d'une antenne 33 reliées à deux des branches 12 du premier groupe 30, formant alors des plages de connexion La et Lb.

Les autres branches 12 forment ici par exemple des plages de connexion I/O (input/output) pour les données, ou « clock ».

A titre d'exemple de réalisation illustré ici, des plages de connexion sont désignées, en sens horaire à partir de la plage La, Gnd et Vccs, les autres étant par exemple configurées pour des transmissions de données.

Les plages de connexion 32 du deuxième groupe 31 représentent ici par exemple des connexions GND et VDD, d'autres plages étant par exemple possiblement configurées pour des transmissions de données.

Dans le présent exemple de réalisation, des fils de connexion 34 relient ainsi des plages de connexion du premier groupe 30 à des plages de connexion du deuxième groupe 31. Par exemple ici la plage Gnd du premier groupe 30 à la plage GND du deuxième groupe 31, et la plage Vccs du premier groupe 30 à la plage VDD du deuxième groupe 31.

Ici, deux des plages de connexion 12 du premier groupe 31 ne se sont pas reliées à une autre plage de connexion, de même que quatre des plages de connexion 32 du deuxième groupe 31.

Une fois les cavités souhaitées formées, par exemple comme décrit précédemment, ici deux cavités, un premier module 40 et un deuxième module 50 sont encartés, respectivement ici dans la première cavité et la deuxième cavité.

Le premier module 40 est ainsi ensuite connecté aux plages de connexion du premier groupe 30, ici formé préalablement par une plaque métallique 10, et le deuxième module 50 est ensuite connecté aux plages de connexion 32 du deuxième groupe 31, aussi ici préalablement formé par une plaque métallique.

A titre d'exemple, pour une meilleure sécurité d'utilisation de certaines cartes électroniques, comme par exemple celles destinées à la réalisation de paiements, une carte électronique peut comporter un capteur biométrique, comme par exemple un capteur d'empreinte digitale, et une puce dédiée (par exemple dite « EMV » pour « Europay Mastercard Visa » qui désigne le standard international de sécurité des cartes de paiement (cartes à puce)) qui traite les données du capteur biométrique. Ainsi, dans un exemple de réalisation considéré ici, le premier module 40 comporte un composant électronique, qui est par exemple une puce, représenté connecté aux plages de connexion du premier groupe 30.

La puce est possiblement disposée sur un support comportant des plages de contact pour une utilisation par contact avec un terminal externe. Le premier module 40 est ainsi par exemple un module dual.

En parallèle, le deuxième groupe 31 de plages de connexion 32 est configuré pour connecter un deuxième module 50 comportant un composant électronique qui est par exemple un capteur biométrique, par exemple un capteur d'empreinte digitale.

La puce du premier module 40 est ainsi d'une part connectée aux plages de connexion du premier groupe 30 et le capteur biométrique est d'autre part connecté aux plages de connexion du deuxième groupe 31, les plages de connexion de chacun de ces deux groupes étant reliées par des fils de connexion 34 afin de connecter la puce au capteur biométrique.

Comme expliqué précédemment, plusieurs connexions doivent donc être établies entre la puce et le capteur biométrique, par exemple ici quatre connexions : par exemple l'alimentation, la masse et deux bus de données.

L'alimentation du capteur biométrique peut ainsi être faite par un régulateur de la puce. Comme aussi illustré figure 4, toutes les plages de connexion ne sont pas utilisées. Ainsi ici par exemple, les deux plages restantes coté puce, peuvent être utilisées en fonction de l'application et/ou du capteur choisi (cela dépend de l'électronique du capteur, de son protocole de communication, etc).

## Revendications

1. Prélaminé pour carte électronique, comportant au moins deux substrats et au moins un premier groupe (30) de plages de connexion assemblées entre les deux substrats, **caractérisé en ce que** le prélaminé comporte une plaque métallique (10) formée d'une pièce comportant une partie centrale (11) et des branches (12) s'étendant depuis la partie centrale (11), les branches (12) de la plaque métallique (10) formant les plages de connexion du premier groupe (30).

2. Prélaminé selon la revendication 1, comportant au moins un deuxième groupe (31) de plages de connexion (32), au moins l'une des plages de connexion du deuxième groupe (31) étant reliée à une des branches (12) de la plaque métallique (10) par un fil de connexion (34).

3. Prélaminé selon la revendication 2, comportant une deuxième plaque métallique (10) formée d'une pièce comportant une partie centrale (11) et des branches (12) s'étendant depuis la partie centrale (11), les branches (12) de la deuxième plaque métallique (10) formant les plages de connexion (32) du deuxième groupe (31).

4. Prélaminé selon l'une quelconque des revendications 1 à 3, comportant une antenne (33) ayant deux extrémités, les deux extrémités de l'antenne (33) étant reliées à deux des branches (12, La, Lb) de la plaque métallique (10) du premier groupe (30).

5. Procédé de réalisation d'un prélaminé, comportant :
- Une étape de fourniture d'au moins deux substrats ;
- Une étape de fourniture d'une plaque métallique (10) formée d'une pièce comportant une partie centrale (11) et des branches (12) s'étendant depuis la partie centrale (11), les branches (12) formant un premier groupe (30) de plages de connexion ;
- Une étape de mise en place de la plaque métallique (10) par rapport à au moins un premier des deux substrats (21) ;
- Une étape de laminage des au moins deux substrats, la plaque métallique (10) étant entre les deux substrats.

6. Procédé selon la revendication 5, dans lequel l'étape de mise en place de la plaque métallique (10) avec au moins le premier des deux substrats (21) comporte une étape d'incrustation de la plaque métallique (10) dans le premier substrat (21).

7. Procédé selon l'une quelconque des revendications 5 ou 6, comportant en outre une étape de fourniture d'un deuxième groupe (31) de plages de connexion (32), et une étape de mise en place d'au moins une des plages de connexion (32) du deuxième groupe (31) à une des branches (12) de la plaque métallique (10) par un fil de connexion (34).

8. Procédé selon l'une quelconque des revendications 5 à 7, comportant en outre une étape de fourniture d'une antenne (34) ayant deux extrémités, et une étape de liaison des deux extrémités de l'antenne (34) à deux des branches (12, La, Lb) de la plaque métallique (10).

9. Procédé de réalisation d'une carte électronique comportant :
- Des étapes de procédé de réalisation d'un prélaminé selon l'une quelconque des revendications 5 à 8 ; et
- Une étape d'usinage comportant au moins une sous-étape de retrait de la partie centrale (11) de la plaque métallique (10) du premier groupe (30) de plages de connexion et une sous-étape de mise à nu d'au moins une des branches (12) de la plaque métallique (10) formant une plage de connexion du premier groupe (30).

10. Procédé selon la revendication 9, comportant en outre une étape de fourniture de deux couches de couverture, et une étape de laminage du prélaminé entre les deux couches de couverture disposées de part et d'autre du prélaminé.

11. Procédé selon l'une quelconque des revendications 9 ou 10, dans lequel l'étape d'usinage comporte en outre une sous-étape de retrait d'une partie centrale (11) d'une plaque métallique (10) formant un deuxième groupe (31) de plages de connexion (32) et une sous-étape de mise à nu d'au moins une plage de connexion (32) du deuxième groupe (31).

12. Procédé selon l'une quelconque des revendications 9 à 11, comportant en outre une étape d'encartage et de connexion d'un premier module (40) à des plages de connexion (12) du premier groupe (30).
